# EUROPEAN PATENT APPLICATION

(11) **EP 4 394 854 A1**
(43) Date of publication of application: **03.07.2024**
(21) Application number: 23212510.4
(22) Date of filing: 28.11.2023
(51) Int. Cl.: H01L 21/677

(54) **AUTOMATED TRANSPORT VEHICLE AND METHOD FOR TRANSPORTING ARTICLE USING THE SAME**

(30) Priority: 28.12.2022 CN 202211706031
(71) Applicant: InnoLux Corporation, Chu-Nan 350, Miao-Li County (TW)
(72) Inventor: CHEN, Chien-Wei, 350 Miao-Li County (TW); HSU, Hsin-Yi, 350 Miao-Li County (TW); LIN, Shiang-Fu, 350 Miao-Li County (TW)
(74) Representative: 2K Patentanwälte Blasberg Kewitz & Reichel

(57) **Abstract**

An automated transport vehicle for transporting an article includes a carrying seat, a mechanical arm and a holding mechanism. The holding mechanism includes at least one first positioning post and at least one second positioning post and, when the holding mechanism holds the article, the first positioning post is in contact with a side surface of the article, and the second positioning post is in contact with a bottom surface of the article.

## Description

### CROSS-REFERENCE TO RELATED APPLICATIONS

This application claims the benefits of the Chinese Patent Application Serial Number 202211706031.X, filed on December 28, 2022, the subject matter of which is incorporated herein by reference.

### BACKGROUND

### Field of the Disclosure

The present disclosure relates to an automated transport vehicle and a method for transporting an article using the automated transport vehicle.

### Description of Related Art

Typically, equipment in the semiconductor packaging industry mostly performs transport operation by manpower. However, in response to problems such as rising labor costs, manpower shortages, or human errors, automated transport equipment is gradually introduced to realize unmanned factories. However, in the market, the automated transport vehicles still encounter defects such as small transport capacity, high transport error rate, or low transport efficiency.

Therefore, there is an urgent need to provide an improved automated transport vehicle to mitigate and/or obviate the aforementioned defects.

### SUMMARY

The present disclosure provides an automated transport vehicle for transporting an article. The automated transport vehicle includes: a carrying seat for accommodating the article; a mechanical arm arranged on the carrying seat; and a holding mechanism connected to the mechanical arm for holding the article, wherein the holding mechanism includes at least one first positioning post and at least one second positioning post and, when the holding mechanism holds the article, the first positioning post is in contact with a side surface of the article, and the second positioning post is in contact with a bottom surface of the article.

The present invention also provides a method of using an automated transport vehicle for transporting an article arranged on a base, which includes: providing an automated transport vehicle including: a carrying seat; a mechanical arm arranged on the carrying seat; a holding mechanism connected with the mechanical arm; and an image capturing module arranged on the mechanical arm; using the image capturing module to capture an image of the base for a first time to calculate a relative position between the automated transport vehicle and the base; using the image capturing module to capture an image of the article to confirm that the article needs to be transported; and using the holding mechanism to move the article from the base to the carrying seat.

Other novel features of the disclosure will become more apparent from the following detailed description when taken in conjunction with the accompanying drawings.

### BRIEF DESCRIPTION OF DRAWINGS

FIG. 1A is a three-dimensional schematic diagram of an automated transport vehicle according to an embodiment of the present disclosure;
FIG. 1B is a top view of the automated transport vehicle of FIG. 1A;
FIG. 2A is a top view of a holding mechanism according to an embodiment of the present disclosure;
FIG. 2B is a side view of the holding mechanism of FIG. 2A;
FIG. 2C is a top view of the holding mechanism holding an article according to an embodiment of the present disclosure;
FIG. 3 is a three-dimensional schematic diagram of a stationary storage apparatus according to an embodiment of the present disclosure;
FIG. 4A is a three-dimensional schematic diagram of a base according to an embodiment of the present disclosure;
FIG. 4B is a top view of the base according to an embodiment of the present disclosure;
FIG. 5A is a three-dimensional schematic diagram of a moveable storage apparatus according to an embodiment of the present disclosure;
FIG. 5B is an enlarged view showing part of the moveable storage apparatus of FIG. 5A; and
FIG. 6A and FIG. 6B are flow charts respectively illustrating methods for transporting an article using the automated transport vehicle according to an embodiment of the present disclosure.

### DETAILED DESCRIPTION OF EMBODIMENT

The implementation of the present disclosure is illustrated by specific embodiments to enable persons skilled in the art to easily understand the other advantages and effects of the present disclosure by referring to the disclosure contained therein. The present disclosure is implemented or applied by other different, specific embodiments. Various modifications and changes can be made in accordance with different viewpoints and applications to details disclosed herein without departing from the spirit of the present disclosure.

It should be noted that, in the specification and claims, unless otherwise specified, having "one" element is not limited to having a single said element, but one or more said elements may be provided. Furthermore, in the specification and claims, unless otherwise specified, ordinal numbers, such as "first", "second", etc., used herein are intended to distinguish elements rather than disclose explicitly or implicitly that names of the elements bear the wording of the ordinal numbers. The ordinal numbers do not imply what order an element and another element are in terms of space, time or steps of a manufacturing method.

In the entire specification and the appended claims of the present disclosure, certain words are used to refer to specific components. Those skilled in the art should understand that electronic device manufacturers may refer to the same components by different names. The present disclosure does not intend to distinguish those components with the same function but different names. In the claims and the following description, the words "comprise", "include" and "have" are open type language, and thus they should be interpreted as meaning "including but not limited to". Therefore, when the terms "comprise", "include" and/or "have" are used in the description of the present disclosure, they specify the existence of corresponding features, regions, steps, operations and/or components, but do not exclude the existence of one or more corresponding features, regions, steps, operations and/or components.

In the description, the terms "almost", "about", "approximately" or "substantially" usually means within 10%, 5%, 3%, 2%, 1% or 0.5% of a given value or range. The quantity given here is an approximate quantity; that is, without specifying "almost", "about", "approximately" or "substantially", it can still imply the meaning of "almost", "about", "approximately" or "substantially". In addition, the term "range of the first value to the second value" or "range between the first value and the second value" indicates that the range includes the first value, the second value, and other values in between.

Unless otherwise defined, all terms (including technical and scientific terms) used here have the same meanings as commonly understood by those skilled in the art of the present disclosure. It is understandable that these terms, such as those defined in commonly used dictionaries, should be interpreted as having a meaning consistent with the relevant technology and the background or context of the present disclosure, rather than in an idealized or excessively formal interpretation, unless specifically defined.

In addition, when a component is said to be connected to another component, it should be understood that the component is directly disposed on the another component, or directly connected to the another component, or there may be other components (not directly) arranged therebetween. Conversely, when a component is said to be "directly on" or "directly connected to" another component, it should be understood that there are no intervening components present therebetween.

In addition, when a component is said to be able to accommodate another component, it should be understood that the other component may be placed inside the component or placed on the component.

In addition, relative terms such as "below" or "bottom", and "above" or "top" may be used in the embodiments to describe the relationship between one component and another component in the drawing. It can be understood that, if the device in the drawing is turned upside down, the components described on the "lower" side will become the components on the "upper" side. When the corresponding member (such as a film or region) is described as "on another member", it may be directly on the other member, or there may be other members between the two members. On the other hand, when a member is described as "directly on another member", there is no member between the two members. In addition, when a member is described as "on another member", the two members have a vertical relationship in the top view direction, and this member may be above or below the other member, while the vertical relationship depends on the orientation of the device.

In the present disclosure, the measurement method of length, height and angle may be obtained by using an optical microscope, and the length, height and angle may be obtained by measuring the cross-sectional image in an electron microscope, but it is not limited thereto. In addition, any two values or directions used for comparison may have certain errors. If the first value is equal to the second value, it implies that there may be an error of about 10% between the first value and the second value. If the first direction is perpendicular to the second direction, the angle between the first direction and the second direction may be in a range of 80 to 100 degrees. If the first direction is parallel to the second direction, the angle between the first direction and the second direction may be in a range of 0 to 10 degrees.

It should be noted that the technical solutions provided by the different embodiments described hereinafter may be used interchangeably, combined or mixed to form another embodiment without violating the spirit of the present disclosure.

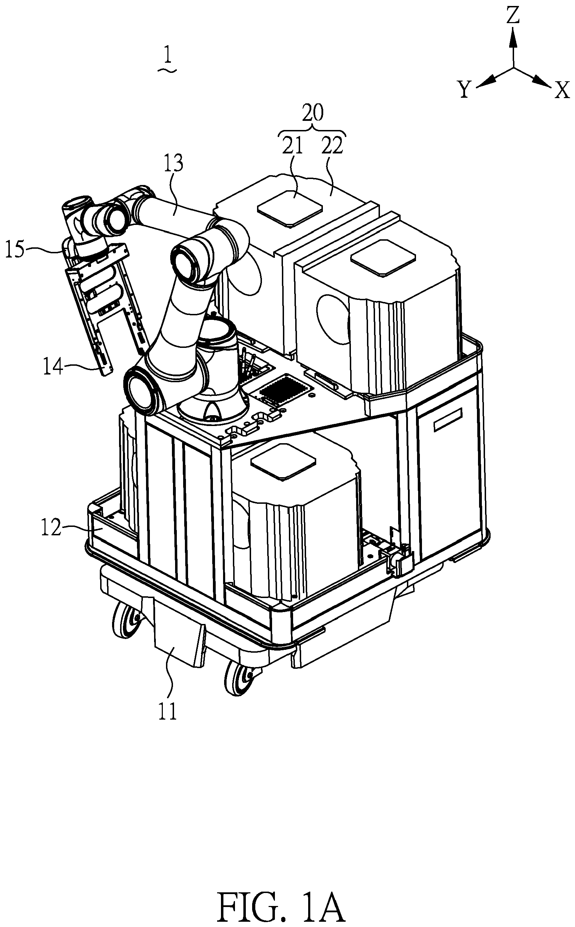

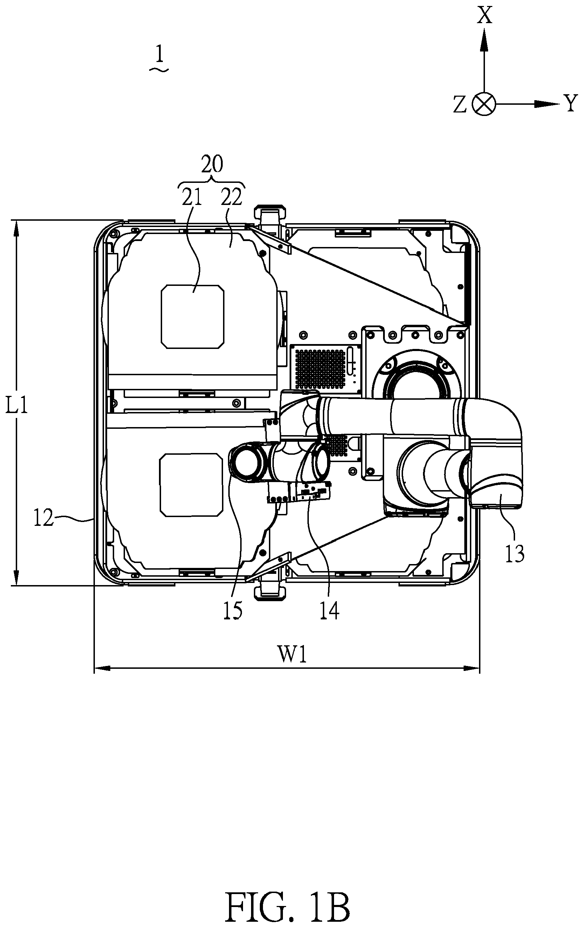

FIG. 1A is a three-dimensional schematic diagram of an automated transport vehicle according to an embodiment of the present disclosure. FIG. 1B is a top view of the automated transport vehicle of FIG. 1A.

As shown in FIG. 1A, the automated transport vehicle 1 of the present disclosure may include: a moving device 11; a carrying seat 12, which is arranged on the moving device 11 to accommodate articles 21; a mechanical arm 13, which is arranged on the carrying seat 12; and a holding mechanism 14, which is connected with the mechanical arm 13, and is used to hold the article 21. In the present disclosure, the article 21 may be moved from a target position to the carrying seat 12 through the holding mechanism 14 connected with the mechanical arm 13, or the article 21 may be moved from the carrying seat 12 to the target position. When the article 21 is on the automated transport vehicle 1, the article 21 may be moved through the moving device 11 so as to achieve the purpose of transporting the article.

In some embodiments of the present disclosure, the moving device 11 may include a control unit (not shown), for example, a computer device, wherein the control unit may be used to set a traveling route or receive a traveling route set by other devices, with which the automated transport vehicle 1 moves to the target position to pick up or place an article, thereby improving the efficiency of automatic transport. In the present disclosure, the moving device 11 may be an autonomous mobile robot (AMR) or an automatic guided vehicle (AGV), but the present disclosure is not limited thereto.

In some embodiments of the present disclosure, the article 21 may be a robotic handling flange, and the article 21 may be connected to a cavity 22. The cavity 22 may be used to accommodate semiconductor devices, such as wafers. Therefore, the article 21 may be connected with the cavity 21 to form a wafer cassette 20, such as a front opening unified pod (FOUP), but the present disclosure is not limited thereto. In the present disclosure, as shown in FIG. 1A, the automated transport vehicle 1 may accommodate four wafer cassettes 20, but the present disclosure is not limited thereto. In another embodiment, the article 21 may be a carrying member, such as a tray or a pallet, and the carrying member may carry glass, panel, metal, frame, semiconductor device or other suitable elements, but it is not limited thereto. In another embodiment, the article 21 may be glass, panel, metal, frame, semiconductor device or other suitable elements, but it is not limited thereto.

In the present disclosure, the automated transport vehicle 1 may further include an image capturing module 15 disposed on the mechanical arm 13. The automated transport vehicle 1 may use the image capturing module 15 to perform alignment and/or image capturing on the transported article, so as to improve the accuracy of the transported article. In addition, although not shown in the figures, the automated transport vehicle 1 of the present disclosure may further include at least one sensor arranged on the carrying seat 12 and/or the moving device 11 for detecting obstacles on the traveling route, thereby reducing the probability of the automated transport vehicle 1 colliding with obstacles during the moving process and thus improving the accuracy or transport efficiency in transporting the article. In addition, although not shown in the figures, the automated transport vehicle 1 of the present disclosure may further include an alarm, which is arranged on the carrying seat 12 and/or the moving device 11. When the sensor detects an obstacle on the traveling route or the image capturing module 15 is abnormal in alignment or imaging, the alarm may be activated to notify with light and/or sound.

In some embodiments of the present disclosure, in the top view of the automated transport vehicle 1, as shown in FIG. 1B, the ratio of the length L1 of the carrying seat 12 to the width W1 of the carrying seat 12 may be between 0.8 and 1.5, such as between 0.85 and 1.45, between 0.85 and 1.4, between 0.85 and 1.35, between 0.85 and 1.3, between 0.85 and 1.25, or between 0.85 and 1.2, but the present disclosure is not limited thereto. In the present disclosure, the "length L1 of the carrying seat 12" refers to the maximum length of the carrying seat 12 in the direction X, and the "width W1 of the carrying seat 12" refers to the maximum width of the carrying seat 12 in the direction Y, wherein the direction X is different from the direction Y. In one embodiment of the present disclosure, the direction X is substantially perpendicular to the direction Y. In some embodiments of the present disclosure, the length L1 of the carrying seat 12 may be about 890 mm, and the width W1 of the carrying seat 12 may be about 830 mm, but the present disclosure is not limited thereto. When the ratio of the length L1 to the width W1 of the carrying seat 12 satisfies the range of the present disclosure, the turning radius of the automated transport vehicle 1 may be reduced and/or the problem of collision with obstacles on the traveling route may be reduced, thereby improving the transport efficiency.

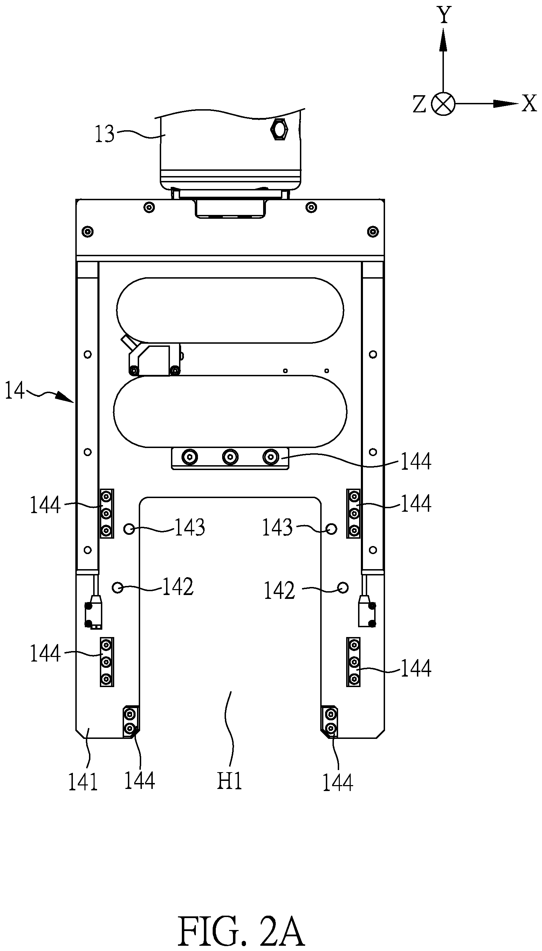

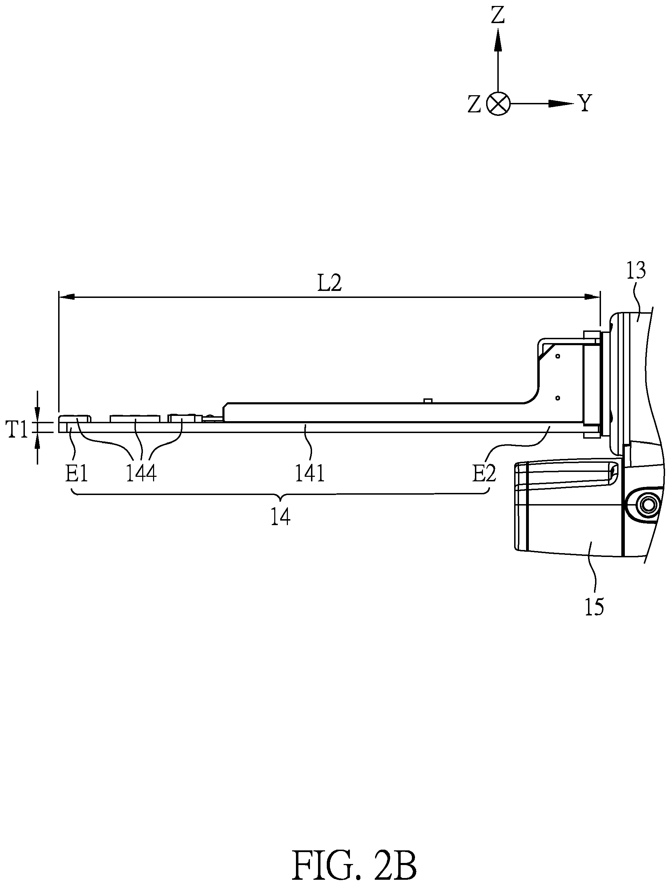

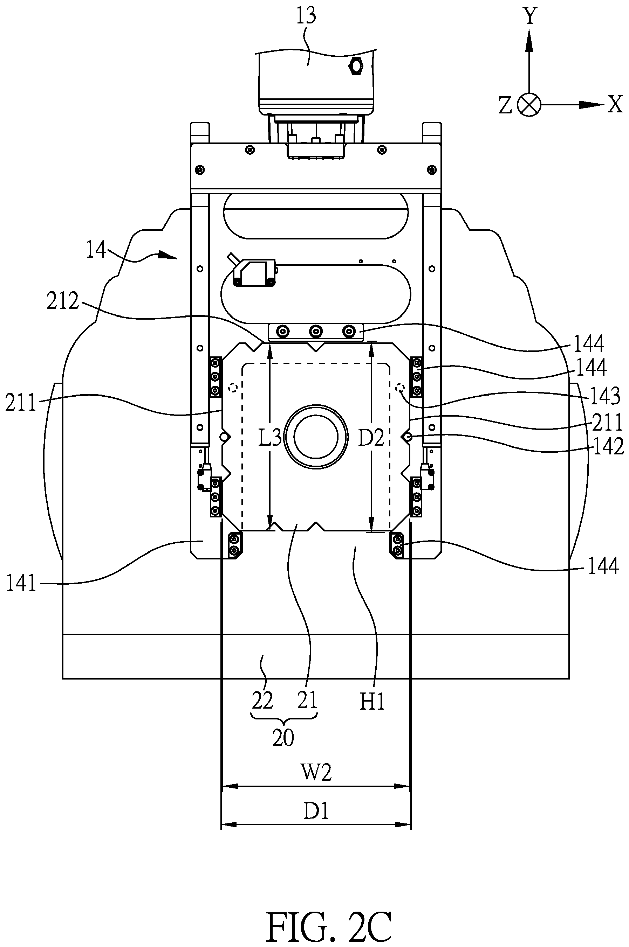

FIG. 2A is a top view of the holding mechanism according to an embodiment of the present disclosure. FIG. 2B is a side view of the holding mechanism of FIG. 2A. FIG. 2C is a top view of the holding mechanism holding an article according to an embodiment of the present disclosure.

As shown in FIG. 2A and FIG. 2B, the holding mechanism 14 of the present disclosure may include a base plate 141, wherein the base plate 141 may have an opening H1; and at least one first positioning post 142 and at least one second positioning post 143 that are arranged on the base plate 141 and adjacent to the opening H1. In some embodiments of the present disclosure, as shown in FIG. 2A, the holding mechanism 14 may include an opening H1, two first positioning posts 142 and two second positioning posts 143, wherein the two first positioning posts 142 are respectively arranged on the left side and the right side of the opening H1, and the two second positioning posts 143 are respectively arranged on the left side and the right side of the opening H1, wherein the second positioning posts 143 are arranged closer to the opening H1 than the first positioning posts 142, More specifically, in the direction X, the minimum distance between the first positioning post 142 and the opening H1 may be greater than the minimum distance between the second positioning post 143 and the opening H1. The first positioning post 142 and the second positioning post 143 may be used to fix the article 21 so that the holding mechanism 14 may hold and transport the article 21.

As shown in FIG. 2C, when the holding mechanism 14 holds the article 21, the first positioning post 142 may be in contact with the side surface 211 of the article 21, and the second positioning post 143 may be in contact with the bottom surface of the article 21; in other words, when the holding mechanism 14 holds the article, in the top view direction of the holding mechanism 14 (e.g., direction Z), the article 21 may overlap with the second positioning post 143 but not overlap with the first positioning post 142. In addition, although not shown in the figures, the bottom surface of the article 21 may be provided with a groove structure, and the groove structure may be arranged corresponding to the second positioning post 143. When the holding mechanism 14 holds the article 21, the second positioning post 143 may be in contact with the groove structure of the bottom surface of the article 21 for fixing the article 21.

In some embodiments of the present disclosure, as shown in FIG. 2B, the thickness T1 of the holding mechanism 14 may be between 3 millimeters (mm) and 15 mm, such as between 3 mm and 12 mm, between 3 mm and 10 mm, between 4 mm and 12 mm, or between 4mm and 10mm, but the present disclosure is not limited thereto. The length L2 of the holding mechanism 14 may be between 260 mm and 400 mm, such as between 280 mm and 380 mm, between 300 mm and 380 mm, or between 300 mm and 360 mm, but the present disclosure is not limited thereto. The ratio of the length L2 of the holding mechanism 14 to the thickness T1 of the holding mechanism 14 may be between 20 and 130, such as between 30 and 110, between 40 and 90, between 40 and 70, or between 50 and 60, but the present disclosure is not limited thereto. In the present disclosure, the "thickness T1 of the holding mechanism 14" refers to the thickness T1 of the base plate 141 of the holding mechanism 14, and the "length L2 of the holding mechanism 14" refers to the length L2 of the base plate 141 of the holding mechanism 14. More specifically, the base plate 141 may include two ends E1, E2, wherein the end E2 may be connected with the mechanical arm 13, and the "length L2 of the holding mechanism 14" refers to the distance between the end E1 of the base plate 141 and the end E2 connected with the mechanical arm 13 in a side view. When the relationship between the length L2 and the thickness T1 of the holding mechanism 14 satisfies the aforementioned range, it is able to improve the reliability of the holding mechanism 14, and reduce the risk of deformation when the holding mechanism 14 holds the article 21.

In the present disclosure, the number of the first positioning posts 142 and the second positioning posts 143 is not particularly limited, and the number of the first positioning posts 142 and the number of the second positioning posts 143 may be the same or different. In the present disclosure, the heights of the first positioning post 142 and the second positioning post 143 are not particularly limited, and the height of the first positioning post 142 and the height of the second positioning post 143 may be the same or different. In some embodiments of the present disclosure, the height of the first positioning post 142 and the height of the second positioning post 143 may each be between 1.5 mm and 4.5 mm, but the present disclosure is not limited thereto. In addition, in the present disclosure, the top surface of the first positioning post 142 may be a plane or a curved surface, and the top surface of the second positioning post 143 may be a curved surface, which is beneficial for holding articles.

In some embodiments of the present disclosure, as shown in FIG. 2A and FIG. 2C, the opening H1 of the holding mechanism 14 may be substantially rectangular, and the opening H1 may be an open opening (in other words, the opening H1 is not enclosed by the base plate 141). When the holding mechanism 14 holds the article 21, in the top view direction of the holding mechanism 14 (e.g., direction Z), the article 21 may at least partially overlap with the base plate 141. In other words, the article 21 may at least partially overlap with the holding mechanism 14, which is beneficial to hold the article 21.

In some embodiments of the present disclosure, the holding mechanism 14 may further include a protrusion 144 disposed on the base plate 141 and adjacent to the opening H1. As shown in FIG. 2A, the holding mechanism 14 may include a plurality of protrusions 144, which may be arranged around the opening H1, so as to increase the stability when holding the article 21. When the holding mechanism 14 holds the article 21, as shown in FIG. 2C, the article 21 does not overlap with the protrusion 144 in the top view direction of the holding mechanism 14 (e.g., direction Z). In some embodiments of the present disclosure, when the holding mechanism 14 holds the article 21, the plurality of protrusions 144 may be in contact with different side surfaces 211 of the article 21; for example, a plurality of protrusions 144 may be in contact with two side surfaces 211 of the article 21 that are opposite to each other, or a plurality of protrusions 144 may be in contact with the side surface 211 and the side surface 212 of the article 21 that are connected with each other.

In addition, as shown in FIG. 2C, when the holding mechanism 14 holds the article 21, in the top view of the holding mechanism 14, in the direction X, the distance D1 between the protrusions 144 respectively disposed on the left and right sides of the article 21 may be greater than or equal to the width W2 of the article 21, and smaller than or equal to the width W2 of the article 21 plus 3mm. In the direction Y, the distance D2 between the protrusions 144 respectively disposed on the upper and lower sides of the article 21 may be greater than or equal to the length L3 of the article 21 and smaller than or equal to the length L3 of the article 21 plus 3 mm. More specifically, the article 21 may have a maximum width W2 in the direction X, and may have a maximum length L3 in the direction Y. When the holding mechanism 14 holds the article 21, in the top view of the holding mechanism 14, the protrusions 144 respectively disposed on the left and right sides of the article 21 may have a minimum distance D1 in the direction X, and the protrusions 144 respectively disposed on the upper and lower sides of the article 21 may have a minimum distance D2 in the direction Y, wherein the distance D1 may be greater than or equal to the width W2 of the article 21 and smaller than or equal to the width W2 of the article 21 plus 3 mm (that is, W2 ≤ D1 ≤ W2 + 3 mm), and the distance D2 may be greater than or equal to the length L3 of the article 21 and smaller than or equal to the length L3 of the article 21 plus 3 mm (that is, L3 ≤ D2 ≤ L3 + 3 mm).

In the present disclosure, the material of the protrusion 144 may include organic materials, such as resin, polyurethane (PU), polyoxymethylene (POM), polycarbonate (PC), polyethylene terephthalate (PET), polypropylene (PP), polystyrene (PS), or a combination thereof, but the present disclosure is not limited thereto. In the present disclosure, the shape of the protrusion 144 is not particularly limited; for example, it may be a rectangle, a circle, an ellipse, an irregular shape, or a combination thereof. In the present disclosure, the number of protrusions 144 is not particularly limited. As shown in FIG. 2A, in some embodiments of the present disclosure, the holding mechanism 14 may include seven protrusions 144, but the present disclosure is not limited thereto, while the number of protrusions 144 may be increased or decreased as required. In addition, in the present disclosure, the size of the protrusion 144 is not particularly limited, and the sizes of the protrusions 144 may be the same or different, while the size of the protrusion 144 may be increased or reduced as required.

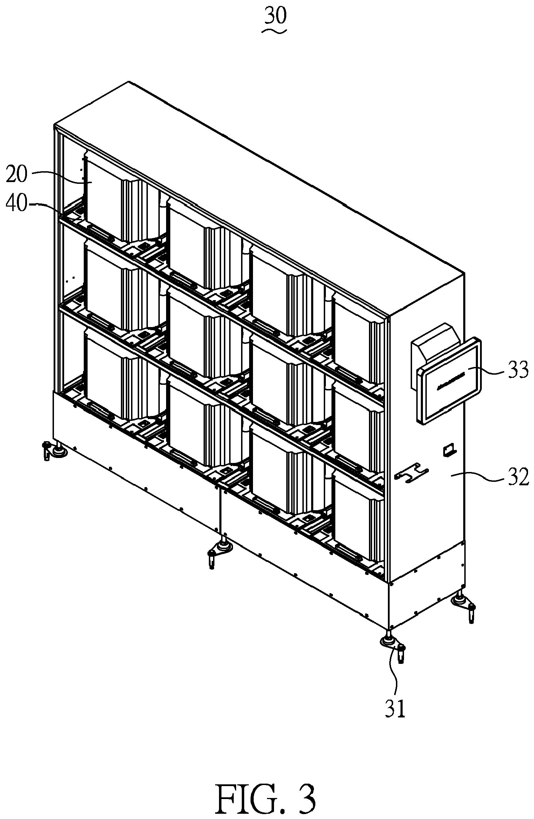

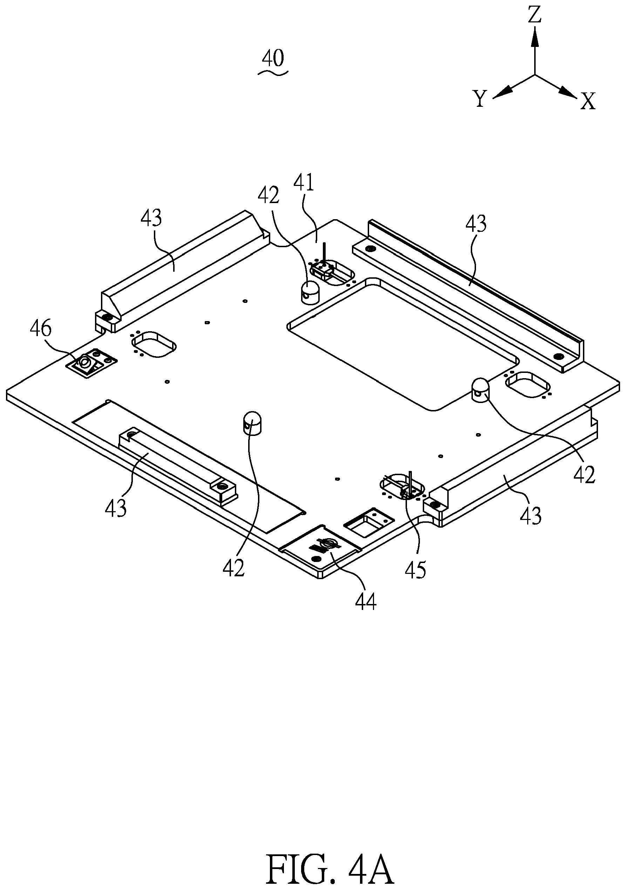

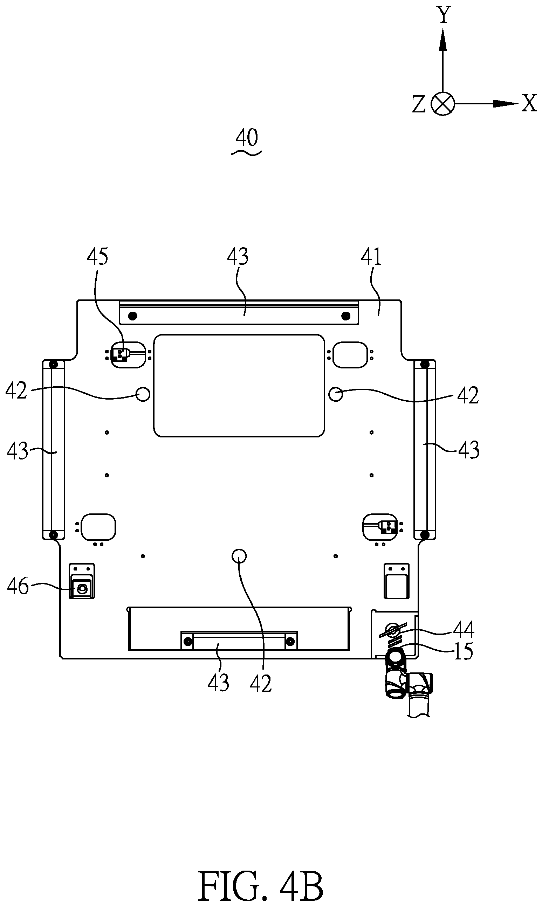

FIG. 3 is a three-dimensional schematic diagram of a stationary storage apparatus according to an embodiment of the present disclosure. FIG. 4A is a three-dimensional schematic diagram of a base according to an embodiment of the present disclosure. FIG. 4B is a top view of the base according to an embodiment of the present disclosure.

In the present disclosure, the automated transport vehicle 1 (as shown in FIG. 1A) may move the article from the target position to the carrying seat 12 of the automated transport vehicle 1 for transportation, or move the article from the carrying seat 12 of the automated transport vehicle 1 to the target position for storage, thereby realizing the function of intelligent storage. The target position may be, for example, a stationary storage apparatus 30. As shown in FIG. 3, the storage apparatus 30 may be provided with a storage space for storing wafer cassettes, for example, and the storage apparatus 30 may be fixed to a specific location through fixing elements 31. More specifically, the storage apparatus 30 may include a plurality of bases 40 disposed on the frame 32, and the bases 40 are used to carry, for example, the wafer cassettes 20 so as to store the wafer cassettes 20 in the storage apparatus 30. In addition, the storage apparatus 30 may further include a monitoring device 33, which may be used to monitor the storage conditions of the wafer cassettes 20 in the storage apparatus 30.

In the present disclosure, the base 40 may be that shown in FIG. 4A and FIG. 4B, and the base 40 may include: a base plate 41; a plurality of positioning elements 42 disposed on the base plate 41; a plurality of limit blocks 43 disposed on the base plate 41 and adjacent to the edge of the base plate 41; and a first mark 44 disposed on the base plate 41.

In the present disclosure, the positioning elements 42 and the limit blocks 43 may be used to fix, for example, the wafer cassette 20 (as shown in FIG. 3), and thus, although not shown in the figure, when the wafer cassette 20 is stored on the base 40, the positioning elements 42 may be in contact with the bottom surface of the wafer cassette 20, and the limit blocks 43 may be adjacent to the side surface of the wafer cassette 20. In other words, when the wafer cassette 20 is stored on the base 40, in the top view direction of the base 40 (e.g., direction Z), the positioning elements 42 may overlap with the wafer cassette 20, and the limit blocks 43 may not overlap with the wafer cassette 20.

In the present disclosure, with the first mark 44, the automated transport vehicle 1 is allowed to perform alignment. More specifically, as shown in FIG. 4B , the automated transport vehicle 1 may capture an image of the first mark 44 on the base plate 41 of the base 40 through the image capturing module 15, so as to calculate the relative position and/or distance between the automated transport vehicle 1 and the base 40. In addition, although not shown in the figures, when the wafer cassette 20 is stored on the base 40, in the top direction of the base 40 (e.g., direction Z), the first mark 44 does not overlap with the wafer cassette 20, which may reduce the disturbance to the image capturing procedure of the image capturing module 15, so that the problems such as abnormal alignment of the automated transport vehicle 1 may be reduced. In the present disclosure, the first mark 44 may be a one-dimensional barcode, a two-dimensional barcode (QR code), a graphic, a mark or a combination thereof, but the present disclosure is not limited thereto.

As shown in FIG. 4A and FIG. 4B, the base 40 may optionally include a sensor 45 and/or an indication unit 46. The sensor 45 may be used to sense whether a wafer cassette 20 is placed on the base 40 or not, and the indication unit 46 may be, for example, a light emitting element (such as an LED light), which may indicate whether the wafer cassette 20 exists or whether it is correctly placed on the base 40. In addition, although not shown in the figures, the base plate 41 of the base 40 may optionally include a groove structure. When the wafer cassette 20 is placed on the base 40, the groove structure may be in contact with the bottom surface of the wafer cassette 20 so as to fix the wafer cassette 20.

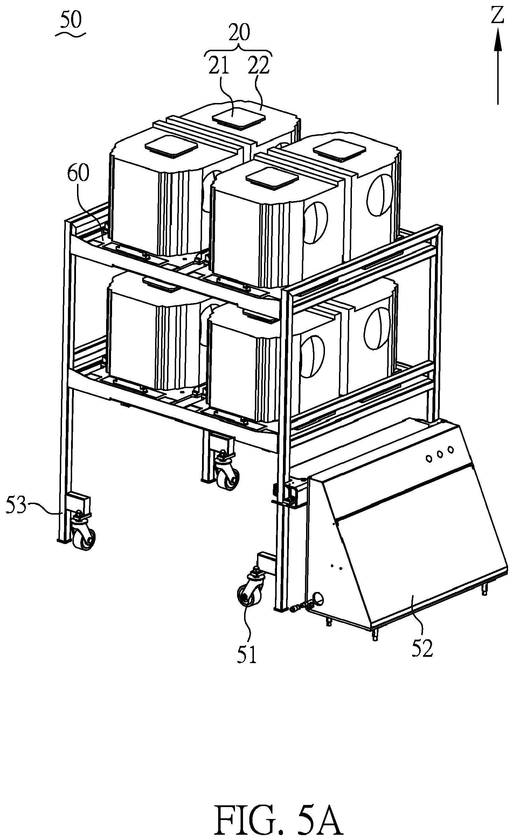

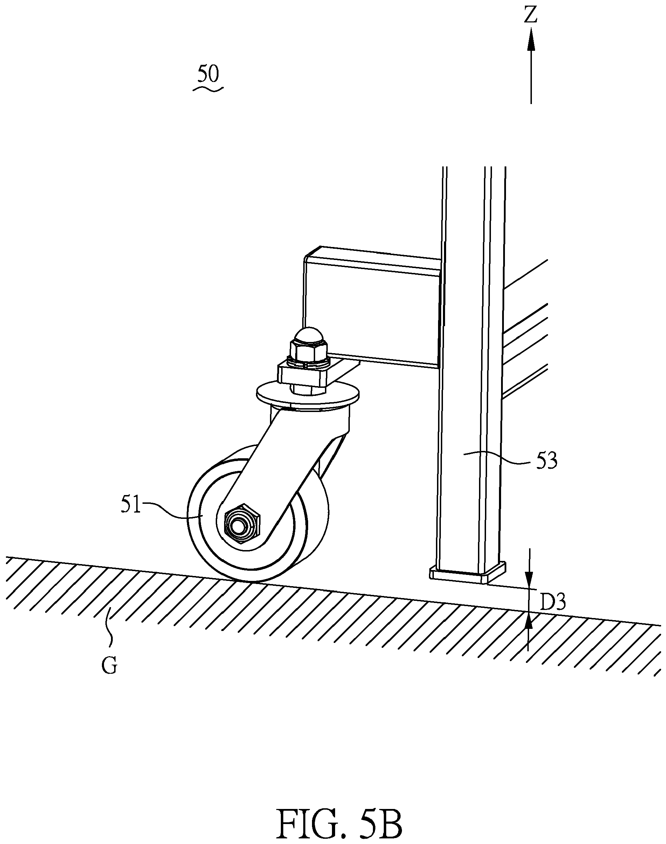

FIG. 5A is a three-dimensional schematic diagram of a moveable storage apparatus according to an embodiment of the present disclosure. FIG. 5B is an enlarged view showing part of the moveable storage apparatus of FIG. 5A.

In the present disclosure, the automated transport vehicle 1 (as shown in FIG. 1A) may move the article from the target position to the carrying seat 12 of the automated transport vehicle 1 for performing carrying, or move the article from the carrying seat 12 of the automated transport vehicle 1 to the target position for storage. The target position may be, for example, a moveable storage apparatus 50. As shown in FIG. 5A, the storage apparatus 50 may be used to temporarily store, for example, the wafer cassettes 20, and may be moved through the moving elements 51 or may be temporarily fixed at a specific location through a fixing module 52. More specifically, the storage apparatus 50 may include a plurality of bases 60 disposed on the frame 53, and the wafer cassettes 20 are carried by the bases 60 so as to store the wafer cassettes 20 in the storage apparatus 50. In the present disclosure, the base 60 of FIG. 5A may be the base 40 shown in FIG. 4A and FIG. 4B, and thus a repeated description is deemed unnecessary. The moving elements 51 may be tires, tracks or a combination thereof.

In some embodiments of the present disclosure, as shown in FIG. 5B, in the top view direction of the storage apparatus 50, the moving elements 51 come into touch with the ground G, and the minimum distance D3 between the frame 53 and the ground G may be greater than or equal to 5mm and smaller than or equal to 10mm. More specifically, when the ground G is flat, the moving elements 51 may be in direct contact with the ground G, and the minimum distance D3 between the frame 53 and the ground G may be greater than or equal to 5mm and smaller than or equal to 10mm. When the ground G is uneven and thus has ups and downs, the minimum distance D3 between the frame 53 and the ground G may be greater than or equal to 5mm and smaller than or equal to 10mm, so that, when the storage apparatus 50 moves, the frame 53 will not affect the movement of the storage apparatus 50.

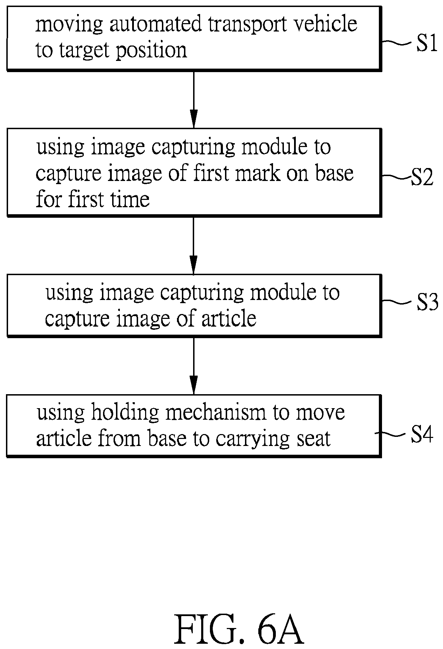

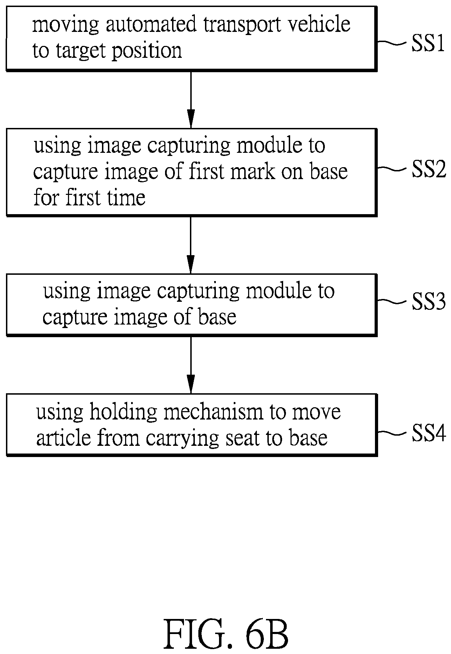

FIG. 6A and FIG. 6B are flow charts respectively illustrating methods for transporting an article using the automated transport vehicle according to an embodiment of the present disclosure.

In some embodiments of the present disclosure, the automated transport vehicle 1 as shown in FIG. 1A may be used to move the article from a designated position (such as the base 40) to the carrying seat 12 of the automated transport vehicle 1, so as to perform transport of the article, wherein the steps may be those shown in FIG. 6A.

First, in step S1, it provides the automated transport vehicle 1 as shown in FIG. 1A, and moves the automated transport vehicle 1 to the target position. Next, in step S2, as shown in FIG. 4B, it uses the image capturing module 15 to capture the image of the first mark 44 on the base 40 for the first time so as to calculate the relative position between the automated transport vehicle 1 and the base 40. In step S3, it uses the image capturing module 15 to capture the image of the article 21 so as to confirm that the article 21 needs to be transported. In step S4, it uses the holding mechanism 14 to move the article 21 from the base 40 to the carrying seat 12, so as to transport the article 21.

In some embodiments of the present disclosure, between step S2 and step S3, a step may optionally be inserted to use the image capturing module 15 to capture the image of the first mark 44 on the base 40 for the second time. In one embodiment of the present disclosure, when the image capturing module 15 captures the image of the first mark 44 for the first time, the distance between the image capturing module 15 and the base 40 may be relatively large, which may generate a large alignment error. Therefore, the image capturing distance between the image capturing module 15 and the first mark 44 may be shortened to perform the image capturing for the second time. That is, the distance between the image capturing module 15 and the base 40 when the image capturing module 15 captures the image of the first mark 44 for the second time is smaller than that when the image capturing module 15 captures the image of the first mark 44 for the first time, so that the alignment accuracy can be improved.

In some embodiments of the present disclosure, after completing the image capturing of the first time (e.g., step S2) and/or completing the image capturing of the second time, and before step S3, a step may be optionally included to calculate the relative position and/or distance between the automated carrying vehicle 1 and the base 40. The relative position and/or distance between the automated carrying vehicle 1 and the base 40 may be calculated by a processor, for example, a computer device (not shown), so as to further calculate the movement of the mechanical arm 13.

In some embodiments of the present disclosure, in step S3, when the image capturing module 15 is used to capture the image of the article 21, the image capturing module 15 may capture the image of the article 21, the cavity 22 or the entire wafer cassette 20. In addition, in some embodiments of the present disclosure, a second mark (not shown) may be provided on the article 21 or on the cavity 22 connected to the article 21, and the second mark may be used to provide the information of the objects (such as wafers) contained in the wafer cassette 20 so as to distinguish different wafer cassettes 20. In the present disclosure, the first mark 44 is different from the second mark, and the second mark may be a one-dimensional barcode, a two-dimensional barcode (QR code), a graphic, a symbol or a combination thereof, but the present disclosure is not limited thereto. Therefore, in some embodiments of the present disclosure, between step S3 and step S4, it may further provided a step of using the image capturing module 15 to capture the image of the second mark. As step S3 may be used to determine whether there is an article stored on the base 40, the step of capturing the image of the second mark may be used to confirm whether the article is a target article to be transported. In some embodiments of the present disclosure, step S3 and the step of capturing the image of the second mark may be performed simultaneously; that is, the image capturing module 15 may capture the image of the article and the second mark at the same time.

In some embodiments of the present disclosure, the automated transport vehicle 1 shown in FIG. 1A may be used to move the article from the carrying seat 12 to the target position (e.g., the base 40) for storage, so as to achieve the purpose of article transport, while the steps may be those shown in FIG. 6B.

First, in step SS1, it provides the automated transport vehicle 1 as shown in FIG. 1A, and moves the automated transport vehicle 1 to the target position. Next, in step SS2, as shown in FIG. 4B, it uses the image capturing module 15 to capture the image of the first mark 44 on the base 40 for the first time. In step SS3, it uses the image capturing module 15 to capture the image of the base 40. In step SS4, it uses the holding mechanism 14 to move the article 21 from the carrying seat 12 to the base 40 so as to transport the article 21. Moreover, in step SS3, the image capturing module 15 may be used to capture the image of the positioning element 42 on the base 40 so as to determine whether there is an article stored on the base 40.

Similarly, in some embodiments of the present disclosure, before step SS3, a step may be further included to use the image capturing module 15 to capture the image of the first mark 44 on the base 40 for the second time. More specifically, the distance between the image capturing module 15 and the base 40 when performing image capturing for the second time is smaller than that when performing image capturing for the first time, so that the alignment accuracy can be improved.

Similarly, in some embodiments of the present disclosure, after completing the image capturing of the first time (e.g., step S2) and/or completing the image capturing of the second time, and before step S3, a step may be optionally included to calculate the relative position and/or distance between the automated transport vehicle 1 and the base 40. The relative position and/or distance between the automated carrying vehicle 1 and the base 40 may be calculated by a processor, for example, a computer device (not shown), so as to further calculate the movement of the mechanical arm 13.

In addition, since the automated transport vehicle 1 of the present disclosure may include sensors and alarms, it is able to perform monitoring at any time during the process of transporting articles, and issue an alarm when an abnormality is detected so as to remove obstacles in real time, thereby improving transport efficiency.

The aforementioned specific embodiments should be construed as merely illustrative, and not limiting the rest of the present disclosure in any way.

## Claims

1. An automated transport vehicle for transporting an article, comprising:
a carrying seat (12) for accommodating the article (21);
a mechanical arm (13) arranged on the carrying seat (12); and
a holding mechanism (14) connected to the mechanical arm (13) for holding the article (21),
wherein the holding mechanism (14) includes at least one first positioning post (142) and at least one second positioning post (143) and, when the holding mechanism (14) holds the article (21), the first positioning post (142) is in contact with a side surface (211) of the article (21), and the second positioning post (143) is in contact with a bottom surface of the article (21).

2. The automated transport vehicle as claimed in claim 1, further comprising an image capturing module (15) disposed on the mechanical arm (13).

3. The automated transport vehicle as claimed in claim 1, wherein, in a top view of the automated transport vehicle (1), a ratio of a length (L1) to a width (W1) of the carrying seat (12) is between 0.8 and 1.5.

4. The automated transport vehicle as claimed in claim 1, wherein the holding mechanism (14) has an opening (H1), and the opening is rectangular.

5. The automated transport vehicle as claimed in claim 4, wherein, when the holding mechanism (14) holds the article (21), in a top view direction of the holding mechanism (14), the article (21) at least partially overlap with the holding mechanism (14).

6. The automated transport vehicle as claimed in claim 1, wherein the holding mechanism (14) further comprises a protrusion (144).

7. The automated transport vehicle as claimed in claim 6, wherein a material of the protrusion (144) includes an organic material.

8. The automated transport vehicle as claimed in claim 6, wherein, when the holding mechanism (14) holds the article (21), the protrusion (144) is in contact with another side surface (211/212) of the article (21).

9. The automated transport vehicle as claimed in claim 4, wherein the holding mechanism (14) includes a base plate (141) having the opening (H1), and the at least one first positioning post (142) and the at least one second positioning post (143) are disposed on the base plate (141) and adjacent to the opening (H1).

10. The automated transport vehicle as claimed in claim 9, wherein the opening (H1) of the holding mechanism (14) is not closed by the base plate (141).

11. The automated transport vehicle as claimed in claim 9, wherein the second positioning post (143) is disposed closer to the opening (H1) than the first positioning post (142).

12. The automated transport vehicle as claimed in claim 1, wherein a top surface of the second positioning post (143) is a curved surface.

13. A method for transporting an article arranged on a base, comprising:
providing an automated transport vehicle (1) including: a carrying seat (12); a mechanical arm (13) arranged on the carrying seat (12); a holding mechanism (14) connected with the mechanical arm (13); and an image capturing module (15) arranged on the mechanical arm (13);
using the image capturing module (15) to capture an image of the base (40) for a first time to calculate a relative position between the automated transport vehicle (1) and the base (40);
using the image capturing module (15) to capture an image of the article (21) to confirm that the article needs to be transported; and
using the holding mechanism (14) to move the article (21) from the base (40) to the carrying seat (12).

14. The method as claimed in claim 13, further comprising: using the image capturing module (15) to obtain a first mark (44) on the base (40) to calculate a relative position between the automated transport vehicle (1) and the base (40).

15. The method as claimed in claim 14, further comprising: before using the image capturing module (15) to capture an image of the article (21), using the image capturing module (15) to capture an image of the first mark (44) on the base (40) for a second time, wherein a distance between the image capturing module (15) and the base (40) when the image capturing module (15) captures an image of the first mark (44) for the second time is smaller than that when the image capturing module (15) captures an image of the first mark (44) for the first time.
